# EUROPEAN PATENT APPLICATION

(11) **EP 1 548 499 A1**
(43) Date of publication of application: **29.06.2005**
(21) Application number: 03730646.1
(22) Date of filing: 27.05.2003
(51) Int. Cl.: G03F 7/075, G03F 7/004, H01L 21/027, C08G 77/54, C08G 77/62

(54) **PHOTOSENSITIVE COMPOSITION FOR INTERLAYER DIELECTRIC AND METHOD OF FORMING PATTERNED INTERLAYER DIELECTRIC**

(30) Priority: 18.07.2002 JP 2002209957
(71) Applicant: AZ Electronic Materials (Japan) K.K., Tokyo 113-0021 (JP)
(72) Inventor: NAGAHARA, T. Clariant (Japan) KK Cntr Off. 9th Fl., Bunkyo-k u, Tokyo 113-8662 (JP); MATSUO, H. Clariant (Japan) KK Cntr Off. 9th Fl., Bunkyo-k u, Tokyo 113-8662 (JP)
(74) Representative: Hörschler, Wolfram Johannes, Dipl.-Ing.
(86) International application number: PCT/JP2003/006613
(87) International publication number: WO 2004/010223

(57) **Abstract**

There is provided a photosensitive composition which possesses excellent storage stability and can yield an interlayer insulation film with an improved film thickness limit. The photosensitive composition comprises a modified polysilsesquiazane having a weight average molecular weight of 500 to 200,000 comprising basic constitutional units represented by formula -[SiR¹(NR²)_{1.5}]- wherein R¹'s each independently represent an alkyl group having 1 to 3 carbon atoms or a substituted or unsubstituted phenyl group; R²'s each independently represent hydrogen, an alkyl group having 1 to 3 carbon atoms, or a substituted or unsubstituted phenyl group, up to 50% by mole of the basic constitutional units having been replaced by a linking group other than the silazane bond; and a photoacid generating agent.

## Description

### TECHNICAL FIELD

The present invention relates to a photosensitive composition, particularly an improvement in a photodecomposable polysilsesquiazane composition that can yield a film which can be finely patterned with high resolution upon exposure to light, and a method for forming a patterned interlayer insulation film using this composition.

### BACKGROUND ART

In the manufacture of semiconductor devices and liquid crystal display devices, an interlayer insulation film is used. In general, an interlayer insulation film is formed by coating or deposition from a gaseous phase, and is then etched through a photoresist to form a pattern. In the case of a fine pattern, however, gaseous phase etching is used. This etching, however, suffers from problems of high apparatus cost and slow processing speed.

On the other hand, the interlayer insulation film is exposed to a high temperature above 400°C during the device manufacture process. Therefore, organic resins as used in conventional resists cannot withstand the high temperature and thus cannot be used as the interlayer insulation film. Patterned silica-based ceramic films are known to be useful as a film, capable of meeting the above material requirement, excellent in heat resistance as well as in abrasion resistance, corrosion resistance, insulating properties, transparency and the like for semiconductor devices, liquid crystal display devices, printed circuit boards and the like.

In particular, when a patterned film is allowed to remain unremoved for use as an interlayer insulation film, the film preferably has low permittivity. In order to meet the above requirement, Japanese Patent Laid-Open No. 181069/2000 discloses a method for forming a patterned polysilazane film, comprising the steps of: forming a coating of a photosensitive polysilazane composition comprising polysilazane and a photoacid generating agent; exposing the coating pattern-wise to light; and dissolving and removing the coating in its exposed area. This publication also discloses a method for forming a patterned insulating film, comprising the step of subjecting the above patterned polysilazane film to standing in an ambient atmosphere or baking to convert the polysilazane film to a silica-based ceramic film.

Further, the applicant of this invention has found that a composition prepared by adding a water-soluble compound as a shape stabilizer to a photosensitive composition comprising a specific modified polysilsesquiazane and a photoacid generating agent can enhance the resolution and, in addition, can form a fine pattern of an interlayer insulation film possessing excellent permittivity and mechanical properties. The application has proposed the above finding as Japanese Patent Application No. 297107/2000. Specifically, the applicant has proposed a photosensitive composition for an interlayer insulation film, comprising: a modified polysilsesquiazane comprising basic constitutional units having a number average molecular weight of 100 to 100,000 and represented by formula -[SiR¹(NR²)_{1.5}]- and 0.1 to 100% by mole, based on the above basic constitutional units, of other constitutional units represented by formulae -[SiR¹₂NR²]- and/or [SiR¹₃(NR²)_{0.5}]- wherein R¹'s each independently represent an alkyl group having 1 to 3 carbon atoms or a substituted or unsubstituted phenyl group and R²'s each independently represent hydrogen, an alkyl group having 1 to 3 carbon atoms, or a substituted or unsubstituted phenyl group; a photoacid generating agent; and a water-soluble compound as a shape stabilizer. The applicant has further proposed a method for forming a patterned interlayer insulation film, comprising the steps of forming a coating of the above photosensitive composition for an interlayer insulation film; exposing the coating pattern-wise to light; dissolving and removing the coating in its exposed area; and subjecting the residual patterned coating to standing in an ambient atmosphere or baking.

The use of the above-described photosensitive composition can eliminate the need to conduct gaseous phase etching and can form an interlayer insulation film having a fine pattern at a low cost. On the other hand, the photosensitive composition described in Japanese Patent Laid-Open No. 181069/2000 has a problem of storage stability. Further, when the above photosensitive compositions are used to form a thick interlayer insulation film, cracking is likely to occur. Therefore, an improvement in film thickness limit is desired. Further, in this case, it is also required that the film thickness limit be improved without sacrificing the photosensitivity of the photosensitive composition and the hardness of the formed interlayer insulation film.

### DISCLOSURE OF THE INVENTION

The present inventor has made extensive and intensive studies with a view to solving the above problems of the prior art and, as a result, has found that the replacement of a part of constitutional units of polysilsesquiazane by a linking group other than the silazane bond can enhance the storage stability of a photosensitive composition without sacrificing the photosensitivity of the photosensitive composition and the hardness of an interlayer insulation film formed from the photosensitive composition and that the selection of the alternative linking group can enhance the film thickness limit of the interlayer insulation film formed from the photosensitive composition. This has led to the completion of the present invention.

The constitution of the present invention will be described below:
[1] A photosensitive composition for an interlayer insulation film, comprising a modified polysilsesquiazane having a weight average molecular weight of 500 to 200,000 comprising basic constitutional units represented by formula -[SiR¹(NR²)_{1.5}]- wherein R¹'s each independently represent an alkyl group having 1 to 3 carbon atoms or a substituted or unsubstituted phenyl group; R²'s each independently represent hydrogen, an alkyl group having 1 to 3 carbon atoms, or a substituted or unsubstituted phenyl group, up to 50% by mole of said basic constitutional units having been replaced by a linking group other than the silazane bond; and a photoacid generating agent.
[2] The photosensitive composition for an interlayer insulation film according to the above item [1], wherein said modified polysilsesquiazane further comprises 0.1 to 100% by mole, based on said basic constitutional units, of other constitutional units represented by formula -[SiR³₂NR²]- and/or [SiR³₃(NR²)_{0.5}]- wherein R³'s each independently represent hydrogen, an alkyl group having 1 to 3 carbon atoms, or a substituted or unsubstituted phenyl group; and R²'s each independently represent hydrogen, an alkyl group having 1 to 3 carbon atoms, or a substituted or unsubstituted phenyl group.
[3] The photosensitive composition for an interlayer insulation film according to the above item [1] or [2], wherein said linking group is represented by formula (I): 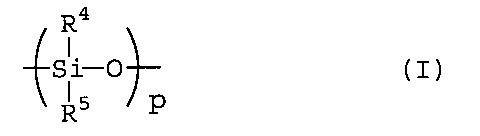 wherein R⁴ and R⁵ each independently represent hydrogen, or an alkyl, alkenyl, cycloalkyl, aryl, aralkyl, alkylamino, alkylsilyl, or alkoxy group; and p is an integer of 1 to 10.
[4] The photosensitive composition for an interlayer insulation film according to the above item [1] or [2], wherein said linking group is represented by formula (II): 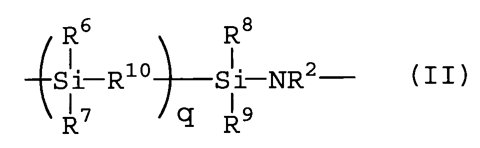 wherein R⁶, R⁷, R⁸, and R⁹ each independently represent an alkyl, alkenyl, cycloalkyl, aryl, aralkyl, alkylamino, alkylsilyl, or alkoxy group; R¹⁰ represents an oxygen atom or an alkylene, alkenylene, cycloalkylene, arylene, alkylimino, or alkylsilylene group; R²'s each independently represent hydrogen, an alkyl group having 1 to 3 carbon atoms, or a substituted or unsubstituted phenyl group; and q is an integer of 1 to 10.
[5] The photosensitive composition for an interlayer insulation film according to the above item [4], wherein R⁶, R⁷, R⁸, and R⁹ represent a methyl group, R¹⁰ represents a phenylene group, R² represents hydrogen, and q is 1.
[6] The photosensitive composition for an interlayer insulation film according to any one of the above items [1] to [5], wherein said photoacid generating agent is selected from the group consisting of sulfoxime compounds and triazine compounds.
[7] The photosensitive composition for an interlayer insulation film according to any one of the above items [1] to [6], which further comprises 0.1 to 40% by mass, based on the photosensitive composition, of a dissolution preventive selected from the group consisting of t-butoxycarbonylated catechol, t-butoxycarbonylated hydroquinone, di-t-butyl benzophenone-4,4'-dicarboxylate, and di-t-butyl 4,4'-oxydibenzolate.
[8] The photosensitive composition for an interlayer insulation film according to any one of the above items [1] to [7], which further comprises a nitro- or carbonic ester-containing water-soluble compound as a shape stabilizer.
[9] The photosensitive composition for an interlayer insulation film according to any one of the above items [1] to [8], which further comprises a sensitizing dye.
[10] A method for forming a patterned interlayer insulation film, comprising forming a coating of a photosensitive composition for an interlayer insulation film, comprising a modified polysilsesquiazane and a photoacid generating agent, said modified polysilsesquiazane having a weight average molecular weight of 500 to 200,000 comprising basic constitutional units represented by formula -[SiR¹(NR²)_{1.5}]- wherein R¹'s each independently represent an alkyl group having 1 to 3 carbon atoms or a substituted or unsubstituted phenyl group, R²'s each independently represent hydrogen, an alkyl group having 1 to 3 carbon atoms, or a substituted or unsubstituted phenyl group, up to 50% by mole of said basic constitutional units having been replaced by a linking group other than a silazane bond; exposing said coating pattern-wise to light; dissolving and removing the coating in its exposed area; and subjecting the resultant patterned coating in an ambient atmosphere to standing or baking.

The present invention will be described in more detail.

### BEST MODE FOR CARRYING OUT THE INVENTION

The photosensitive composition for an interlayer insulation film according to the present invention is a polysilsesquiazane-type positive-working photoresist. Upon exposure of a coating of the photosensitive composition to light in a pattern-wise manner, Si-N bonds of the polysilsesquiazane in the exposure area of the coating are cleaved, and the cleaved parts are further reacted with moisture in an ambient atmosphere to give silanol (Si-OH) bonds. That is, when the coating after the exposure is developed, the photosensitive composition in its exposed area is dissolved and removed while the unexposed area stays on the substrate to form a pattern (a positive-working pattern). Thus, the photosensitivity of the polysilsesquiazane-type positive-working photoresist is relied upon the Si-N bonds as basic constitutional units of the polysilsesquiazane-type positive-working photoresist. Therefore, the replacement of a part of the Si-N bonds by a linking group other than the silazane bond reduces the number of Si-N bonds which are sites cleaved upon exposure. This is considered to result in lowered photosensitivity of the polymer per se. However, it has been found that, even when all the Si-N bonds are not converted to Si-OH bonds, in the subsequent development treatment, the exposed area is completely removed as a mass comprised of a plurality of basic constitutional units. That is, it has been found that, even when a part of the basic constitutional units of polysilsesquiazane is replaced by a nonphotosensitive bond other than the Si-N bond, the photosensitivity as the photoresist can be satisfactorily ensured without sacrificing the removability of the exposed area. Based on such finding, according to the present invention, the modification of polysilsesquiazane on a level, which does not sacrifice the photosensitivity of the photosensitive composition as a photoresist, can enhance the storage stability of the photosensitive composition and, at the same time, can realize an improvement in film thickness limit of an interlayer insulation film formed upon conversion of the photosensitive composition film to a ceramic while maintaining high hardness.

The modified polysilsesquiazane contained in the photosensitive composition for an interlayer insulation film according to the present invention comprises basic constitutional units represented by formula - [SiR¹(NR²)_{1.5}]-. Up to 50% by mole of the basic constitutional units have been replaced by a linking group other than the silazane bond. In the formula, R¹'s each independently represent an alkyl group having 1 to 3 carbon atoms or a substituted or unsubstituted phenyl group; and R²'s each independently represent hydrogen, an alkyl group having 1 to 3 carbon atoms, or a substituted or unsubstituted phenyl group. Preferably, R¹ represents a methyl or phenyl group, most preferably a methyl group. Preferably, R² represents hydrogen.

The linking group, by which up to 50% by mole of the basic constitutional units is replaced, may be one represented by formula (I): 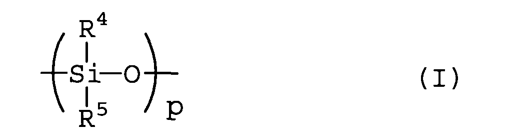 wherein R⁴ and R⁵ each independently represent hydrogen, or an alkyl, alkenyl, cycloalkyl, aryl, aralkyl, alkylamino, alkylsilyl, or alkoxy group; and p is an integer of 1 to 10. The replacement of the above basic constitutional units by this linking group can improve the storage stability of the photosensitive composition. The reason for this is believed to be as follows. In the case of polysilsesquiazane consisting of basic constitutional units in a trifunctional form alone, a number of distorted cyclic structures, which are cleaved during storage, are present in its molecule and cleaved parts recombine with similarly cleaved other molecules to increase the molecular weight. On the other hand, the replacement of a part of the basic constitutional units by a linking group other than the silazane bond can reduce the number of distorted cyclic structures. This is considered to suppress an increase in molecular weight caused by the above cleavage and recombination.

R⁴ and R⁵ generally represent an alkyl group having 1 to 7 carbon atoms, preferably 1 to 5 carbon atoms, more preferably 1 or 2 carbon atoms, an alkenyl group having 2 to 7 carbon atoms, a cycloalkyl group having 5 to 7 carbon atoms, or an aryl group. More specific examples of R⁴ and R⁵ include phenyl, tolyl, xylyl, cumenyl, benzyl, phenethyl, α-methylbenzyl, benzhydryl, trityl, styryl, cinnamyl, biphenyl, and naphthyl groups. The alkylsilyl group (mono-, di-, or tri-substituted), the alkylamino group (mono- or di-substituted), and the alkoxy group generally have 1 to 7 carbon atoms. R⁴ and R⁵ may be the same or different. p is preferably 1 to 5, most preferably 2.

According to the present invention, as described above, an enhancement in storage stability of the photosensitive composition and, at the same time, an enhancement in film thickness limit of an interlayer insulation film formed from the photosensitive composition without sacrificing the hardness of the interlayer insulation film can be realized by using, as the above linking group, a group represented by formula (II): 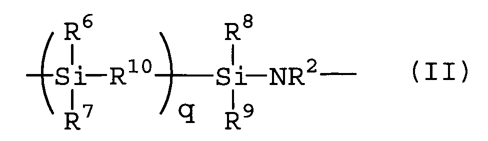 wherein R⁶, R⁷, R⁸, and R⁹ each independently represent an alkyl, alkenyl, cycloalkyl, aryl, aralkyl, alkylamino, alkylsilyl, or alkoxy group; R¹⁰ represents an oxygen atom or an alkylene, alkenylene, cycloalkylene, arylene, alkylimino, or alkylsilylene group; R²'s each independently represent hydrogen, an alkyl group having 1 to 3 carbon atoms, or a substituted or unsubstituted phenyl group; and q is an integer of 1 to 10.

R⁶, R⁷, R⁸, and R⁹ generally represent an alkyl group having 1 to 7 carbon atoms, preferably 1 to 5 carbon atoms, more preferably 1 or 2 carbon atoms (particularly a methyl group), an alkenyl group having 2 to 7 carbon atoms, a cycloalkyl group having 5 to 7 carbon atoms, or an aryl group. More specific examples of R⁶, R⁷, R⁸, and R⁹ include phenyl, tolyl, xylyl, cumenyl, benzyl, phenethyl, α-methylbenzyl, benzhydryl, trityl, styryl, cinnamyl, biphenyl, and naphthyl groups. The alkylsilyl group (mono-, di-, or tri-substituted), the alkylamino group (mono- or di-substituted), and the alkoxy group generally have 1 to 7 carbon atoms. R⁶, R⁷, R⁸, and R⁹ may be the same or different. R¹⁰ generally represents an alkylene group having 1 to 7 carbon atoms, preferably 1 to 5 carbon atoms, more preferably 1 or 2 carbon atoms, an alkenylene group having 2 to 7 carbon atoms, a cycloalkylene group having 5 to 7 carbon atoms, an arylene group, an alkylimino group having 1 to 7 carbon atoms, or an alkylsilylene group having 1 to 7 carbon atoms. More specific examples thereof include phenylene, tolylene, xylylene, benzylidene, phenethylidene, α-methylbenzylidene, cinnamylidene, and naphthylene groups. The arylene group is particularly preferably a phenylene group. Preferably, R² represents hydrogen. q is preferably 1 to 5, most preferably 1.

Up to 50% by mole of the basic constitutional units of the polysilsesquiazane has been replaced by the linking group other than the silazane bond. Effects of the present invention, that is, an improvement in storage stability of the photosensitive composition according to the present invention and an improvement in film thickness limit, can be attained by the presence of the linking group. Therefore, there is no need to specify the lower limit of the percentage replacement as a technical idea. In order to attain the effects of the present invention on a satisfactory level, however, in general, the percentage replacement of the basic constitutional units by the linking group is suitably not less than 0.1 % by mole, preferably not less than 1% by mole. On the other hand, in general, the upper limit of the percentage replacement is suitably not more than 50% by mole, preferably not more than 45% by mole, more preferably not more than 40% by mole, from the viewpoint of avoiding the sacrifice of desired photosensitivity of the photosensitive composition for an interlayer insulation film. The form of replacement of the basic constitutional units by the linking group according to the present invention is random. Further, in the modified polysilsesquiazane according to the present invention, the linking group represented by formula (I) and the linking group represented by formula (II) may be present in a mixed form.

The modified polysilsesquiazane according to the present invention may further comprise 0.1 to 100% by mole, based on said basic constitutional units, of other constitutional units represented by formula -[SiR³₂NR²]- and/or [SiR³₃(NR²)_{0.5}]- wherein R³'s each independently represent hydrogen, an alkyl group having 1 to 3 carbon atoms, or a substituted or unsubstituted phenyl group; and R²'s each independently represent hydrogen, an alkyl group having 1 to 3 carbon atoms, or a substituted or unsubstituted phenyl group. As compared with the polysilsesquiazane comprised of trifunctional basic constitutional units alone, the replacement of the basic constitutional units by the difunctional constitutional units and/or the monofunctional constitutional units can suppress an increase in molecular weight of the polysilsesquiazane and can further enhance the storage stability of the photosensitive composition.

These other constitutional units are randomly bonded to the basic constitutional units. Each of R¹, R², and R³ may be independently selected. Therefore, each of these groups may be the same or different between basic constitutional units. Further, each of them may be the same or different between basic constitutional units and other constitutional units. For example, possible embodiments include one wherein, in the basic constitutional units, a part of R¹ represents methyl with the remaining R¹ representing phenyl, one wherein, in the basic constitutional units, a part of R² represents hydrogen with the remaining R² representing methyl, one wherein R¹ in the basic constitutional units represents methyl while R³ in other constitutional units represents methyl or phenyl, one wherein R² in the basic constitutional units represents hydrogen while R³ in other constitutional units represents hydrogen or methyl. Preferably, for both the basic constitutional units and the other constitutional units, R¹ and R³ represent a methyl or phenyl group, most preferably a methyl group. Further, for both the basic constitutional units and the other constitutional units, preferably, R² represents hydrogen.

The modified polysilsesquiazane comprising the above other constitutional units comprises 0.1 to 100% by mole, preferably 0.5 to 40% by mole, more preferably 1 to 20% by mole, based on the basic constitutional units, of other constitutional units represented by formula - [SiR³₂NR²]- and/or [SiR³₃(NR²)_{0.5}]-. When only constitutional units represented by formula -[SiR³₂NR²]- are contained as other constitutional units, the content of the constitutional units based on the basic constitutional units is preferably 0.1 to 100% by mole, more preferably 1 to 20% by mole. On the other hand, when only constitutional units represented by formula [SiR³₃(NR²)_{0.5}]- are contained as other constitutional units, the content of the constitutional units based on the basic constitutional units is preferably 0.1 to 50% by mole, more preferably 0.5 to 20% by mole. When the content of these other constitutional units exceeds 100% by mole, the molecular weight of the polymer is not satisfactorily high. Consequently, disadvantageously, the coating becomes fluid.

The weight average molecular weight of the modified polysilsesquiazane according to the present invention is in the range of 500 to 200,000, preferably 600 to 150,000. When the weight average molecular weight of the modified polysilsesquiazane is smaller than 500, the coating becomes fluid. On the other hand, when the weight average molecular weight of the modified polysilsesquiazane is larger than 200,000, the dissolution of the photosensitive composition in a solvent is difficult. Both the above cases are unfavorable.

The modified polysilsesquiazane according to the present invention can be easily prepared in ammonolysis for synthesizing conventional polysilazane, by using, as starting materials, R¹SiCl₃ and a monomer, from which a linking group other than a silazane bond may be derived, so that the molar ratio of the monomer used corresponds to the replacement ratio of the linking group. For example, when the linking group to be incorporated is a group represented by formula (I), ammonolysis may be carried out using a silane starting material prepared by mixing Cl(Si(R⁴)(R⁵)O)ₚSi(R¹)Cl₂ into R¹SiCl₃. In this case, in calculating the molar ratio corresponding to the replacement ratio of the linking group, the numeric value p in the monomer should be taken into consideration because the Si(R¹)Cl₂ part of Cl(Si(R⁴)(R⁵)O)ₚSi(R¹)Cl₂ is incorporated in the basic constitutional units. For example, in the case of p = 1, when R¹SiCl₃ and ClSi(R⁴)(R⁵)OSi(R¹)Cl₂ are mixed together in a molar ratio of 1 : 1, the replacement ratio of the linking group is about 33%. In the case of p = 2, when R¹SiCl₃ and Cl(Si(R⁴)(R⁵)O)₂Si(R¹)Cl₂ are mixed together in a molar ratio of 2 : 1, the replacement ratio of the linking group is 40%. On the other hand, when the linking group represented by formula (II) is contained as the linking group, ammonolysis may be carried out using a starting material prepared by mixing R¹SiCl₃ and Cl(Si(R⁶)(R⁷)R¹⁰)_{q}Si(R⁸)(R⁹)Cl in a molar ratio corresponding to the replacement ratio of the linking group independently of the q value. For example, when the former and the latter are mixed together in a molar ratio of 9 : 1, the replacement ratio of the linking group is 10%.

The modified polysilsesquiazane containing the above other constitutional units can be easily prepared in ammonolysis for synthesizing conventional polysilazane, by using R¹SiCl₃, R¹₂SiCl₂ and/or R¹₃SiCl as starting materials so that R¹₂SiCl₂ and R¹₃SiCl are used in a molar ratio corresponding to the content ratio of the above other constitutional units. For example, when 20% by mole of constitutional units represented by formula -[SiR¹₂NR²]- is contained as other constitutional units, ammonolysis may be carried out using a silane starting material prepared by mixing 20% by mole of R¹₂SiCl₂ into R¹SiCl₃. Likewise, when 10% by mole of constitutional units represented by formula [SiR¹₃(NR²)_{0.5}]- is contained as other constitutional units, 10% by mole of R¹₃SiCl may be mixed into R¹SiCl₃.

For details of ammonolysis in synthesizing polysilazane, reference may be made, for example, to Japanese Patent Publication No. 16325/1988.

The photosensitive composition according to the present invention contains a photoacid generating agent. The photoacid generating agent is brought into an excited state directly by exposure to light in its inherent photosensitive wavelength region. Alternatively, when a sensitizing dye is used, the photoacid generating agent is brought into an excited state indirectly by exposure to light in its wavelength region which can excite the sensitizing dye. The excited photoacid generating agent cleaves Si-N bonds in the modified polysilsesquiazane, and the cleaved parts are considered to be reacted with moisture in the atmosphere to give silanol (Si-OH) bonds. Since the silanol is soluble in a developer which will be described later, the coating of the photosensitive composition only in its light exposed area is dissolved and removed to provide a positive-working patterning.

The photoacid generating agent may be a peroxide. Specific examples of peroxides as the photoacid generating agent include 3,3',4,4'-tetra(t-butylperoxycarbonyl)benzophenone, t-butylperoxybenzoate, methyl ethyl ketone peroxide, cyclohexanone peroxide, methylcyclohexanone peroxide, methyl acetoacetate peroxide, acetylacetone peroxide, 1,1-bis(t-hexylperoxy)-3,3,5-trimethylcyclohexane, 1, 1-bis(t-hexylperoxy)cyclohexane, 1,1-bis(t-butylperoxy)-3,3,5-trimethylcyclohexane, di-t-butylperoxy-2-methylcyclohexane, 1,1-bis(t-butylperoxy)cyclohexane, 1,1-bis(t-butylperoxy)cyclododecane, 2,2-bis(t-butylperoxy)butane, n-butyl 4,4-bis(t-butylperoxy)valerate, 2,2-bis(4,4-di-t-butylperoxycyclohexyl)propane, p-menthanehydroperoxide, diisopropylbenzenehydroperoxide, 1,1,3,3-tetramethylbutylhydroperoxide, cumene hydroperoxide, t-hexylhydroperoxide, t-butylhydroperoxide, α,α'-bis(t-butylperoxy)diisopropylbenzene, dicumyl peroxide, 2,5-dimethyl-2,5-bis(t-butylperoxy)hexane, t-butylcumyl peroxide, di-t-butyl peroxide, 2,5-dimethyl-2,5-bis(t-butylperoxy)hexyne-3, isobutylyl peroxide, 3,5,5-trimethylhexanoyl peroxide, octanoyl peroxide, lauroyl peroxide, stearoyl peroxide, succinic acid peroxide, m-toluoylbenzoyl peroxide, benzoyl peroxide, di-n-propylperoxydicarbonate, diisopropylperoxydicarbonate, bis(4-t-butylcyclohexyl)peroxydicarbonate, di-2-ethoxyethylperoxydicarbonate, di-2-ethylhexylperoxydicarbonate, di-3-methoxybutylperoxydicarbonate, di(3-methyl-3-methoxybutyl)peroxydicarbonate, α,α'-bis(neodecanoylperoxy)diisopropylbenzene, cumylperoxyneodecanoate, 1,1,3,3-tetramethylbutylperoxyneodecanoate, 1-cyclohexyl-1-methylethylperoxyneodecanoate, t-hexylperoxyneodecanoate, t-butylperoxyneodecanoate, t-hexylperoxypivalate, t-butylperoxypivalate, 1,1,3,3-tetramethylbutylperoxy-2-ethylhexanoate, 2,5-dimethyl-2,5-bis(2-ethylhexanoylperoxy)hexane, 1-cyclohexyl-1-methylethylperoxy-2-ethylhexanoate, t-hexylperoxy 2-ethylhexanoate, t-butylperoxy 2-ethylhexanoate, t-butylperoxyisobutyrate, t-hexylperoxyisopropylmonocarbonate, t-butylperoxymaleic acid, t-butylperoxy 3,5,5-trimethylhexanoate, t-butylperoxylaurate, 2,5-dimethyl-2,5-(m-toluoylperoxy)hexane, t-butylperoxyisopropylmonocarbonate, t-butylperoxy 2-ethylhexylmonocarbonate, t-hexylperoxybenzoate, 2,5-dimethyl-2,5-bis(benzoylperoxy)hexane, t-butylperoxyacetate, t-butylperoxy-m-toluoylbenzoate, bis(t-butylperoxy)isophthalate, t-butylperoxyallylmonocarbonate, t-butyltrimethylsilyl peroxide, and 1,3-di(t-butylperoxycarbonyl)benzene.

The photoacid generating agent may be a naphthoquinonediazidosulfonic ester or a nitrobenzyl ester. Specific examples of naphthoquinonediazidosulfonic esters as the photoacid generating agent include 1,2-naphthoquinone-(2)-diazido-5-sulfonic acid chloride, 1,2-naphtoquinone-(2)-diazido-4-sulfonic acid chloride, an (mono- to tri-) ester of 2,3,4-trihydroxybenzophenon with 6-diazo-5,6-dihydro-5-oxo-naphthalene-1-sulfonic acid, and an (mono- to tri-) ester of 2,3,4,4'-trihydroxybenzophenon with 6-diazo-5,6-dihydro-5-oxo-naphthalene-1-sulfonic acid. Specific examples of nitrobenzyl esters as the photoacid generating agent include nitrobenzyl tosylate, dinitrobenzyl tosylate, nitrobenzyl chloride, dinitrobenzyl chloride, nitrobenzyl bromide, dinitrobenzyl bromide, nitrobenzyl acetate, dinitrobenzyl acetate, nitrobenzyltrichloroacetate, and nitrobenzyltrifluoroacetate. Other useful photoacid generating agents include benzoin tosylate, nitrobenzylsulfonic acids, and onium salts (for example, bis(4-t-butylphenyl)iodonium salt and triphenyl sulfonium salt). If necessary, these photoacid generating agents may be used in combination.

In the photosensitive composition according to the present invention, the photoacid generating agent is generally contained in an amount of 0.05 to 50% by mass based on the mass of the modified polysilsesquiazane. When the content of the photoacid generating agent is less than 0.05% by mass, the decomposition reaction rate is very low. On the other hand, when the content of the photoacid generating agent is more than 50% by mass, a dense film which is a modified polysilsesquiazane-derived feature cannot be formed without difficulties. The content of the photoacid generating agent is preferably 0.1 to 20% by mass, more preferably 1 to 20% by mass, based on the mass of the modified polysilsesquiazane.

When the photosensitive composition comprising the modified polysilsesquiazane and the photoacid generating agent should be stored for a given period of time or longer, some photoacid generating agents including nitrobenzylsulfonic esters have a fear of being decomposed by a very small amount of NH₃ liberated from the modified polysilsesquiazane during storage. In this case, the selection of a base-resistant photoacid generating agent can improve the storage stability of the photosensitive composition. Base-resistant photoacid generating agents include iminosulfonate derivatives, disulfone derivatives, diazomethane derivatives, and other photoacid generating agents, for example, sulfoxime compounds such as 4-methoxy-α-((((4-methoxyphenyl)sulfonyl)oxy)imino)benzeneacetonitrile and triazine compounds such as compounds represented by the following formula.

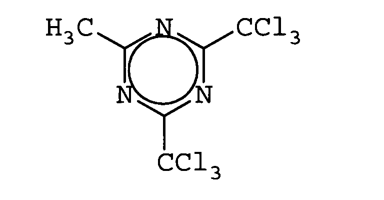

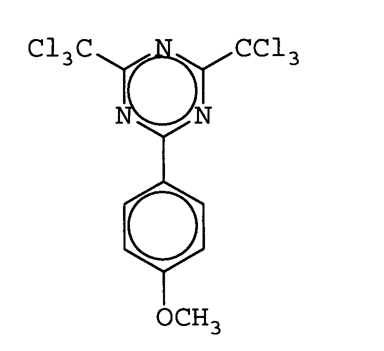

The photosensitive composition according to the present invention may further comprise a water-soluble compound as a shape stabilizer. The shape stabilizer refers to an agent which can increase the steepness of a side wall of the section of a pattern formed by removing the light exposed area.

As described above, in the modified polysilsesquiazane according to the present invention, the Si-N bond is cleaved by light irradiation, and the cleaved parts are then reacted with moisture in the atmosphere to give a silanol bond. In this case, since the modified polysilsesquiazane is highly hydrophobic, the formation of the silanol bond rapidly takes place in a portion near the coating surface in contact with the moisture-containing atmosphere. In the coating in its inside not in contact with the moisture-containing atmosphere, however, as the portion is closer to the interface of the substrate and the coating, the amount of water, which permeates and arrives at this portion through the coating surface, is smaller. Therefore, the formation of the silanol bond is less likely to occur. For this reason, the modified polysilsesquiazane coating has such a sensitivity difference that the photosensitivity lowers from the surface toward the interface of the substrate. Therefore, as the portion is closer to the coating surface, the silanol bond is more easily formed and the portion is more easily dissolved and removed by the development. Consequently, the side wall of the section of the pattern becomes gently sloped. This phenomenon is causative of a limitation on pattern refinement or improved resolution. In this case, when a water-soluble compound is added as the shape stabilizer, the side wall of the section of the pattern can be made steep and the resolution can be enhanced. Specifically, the addition of the water-soluble compound can lower the hydrophobicity of the photosensitive coating and can accelerate access of water from the coating surface in contact with the moisture-containing atmosphere to the inside of the coating. Therefore, the difference in silanol bond formation rate between the coating in its portion near the surface and the coating in its portion near the interface of the coating and the substrate, that is, sensitivity difference, becomes small. This can lower irradiation light energy necessary for satisfactorily dissolving and removing the coating in its portion corresponding to the mask opening to a position near the interface of the coating and the substrate and, in its turn, can lower energy of "light oozing" to the mask shielded part. In the part where the energy of "oozed light" has been reduced to a level that is too small to cleave the Si-N bond of the modified polysilsesquiazane, even when the part is exposed indirectly to the "oozed light," the silanol bond is not formed. Therefore, that part is not dissolved and removed during development. Consequently, in the mask shielded part, the dissolution and removal of that part is reduced, and the side wall of the section of the pattern is made steep, and most preferably vertical.

It could be easily understood that rendering the side wall of the section of the pattern steep can be achieved independently of the level of the phtotosensitivity of the photosensitive composition. Specifically, when the photosensitivity of the photosensitive composition in its part near the substrate is high, as described above, the side wall of the section of the pattern can be made steep by lowering the irradiation light energy. Further, for example, when the photosensitivity of the whole photosensitive composition has been lowered due to the addition of the water-soluble compound according to the present invention, in some cases, the irradiation light energy necessary for satisfactorily dissolving and removing the coating in its part corresponding to the opening of the mask to the position near the interface of the coating and the substrate should be enhanced. In this case, however, since the energy of the "oozed light" necessary for cleaving the Si-N bond in the modified polysilsesquiazane in its mask shielded part is also similarly enhanced, the side wall of the section of the pattern can be similarly made steep when the sensitivity difference of the coating is small. In short, the side wall of the section of the pattern can be made steep independently of the photosensitivity level of the photosensitive composition by reducing the difference in photosensitivity between the part near the coating in its surface and the coating in its part near the interface of the coating and the substrate.

Even when the water-soluble compound is insoluble in neutral water, the water-soluble compound is useful so far as it is soluble in acidic or basic water. The reason for this is that, when the water-soluble compound is soluble in acidic water, the radiation exposed area is made acidic by an acid generated from the photoacid generating agent while, when the water-soluble compound is soluble in basic water, the penetration of the developer can be accelerated during development with an aqueous alkaline solution. In any case, access of water from the surface of the coating to the inside of the coating is accelerated, and, thus, the difference in sensitivity between the coating in its part near the surface and the coating in its part near the interface of the coating and the substrate becomes small.

The water-soluble compound according to the present invention may be a monomer or a polymer. A solubility of the water-soluble compound in neutral water, acidic water, or basic water of not less than about 0.01 g/100 mL suffices for contemplated results, and the water-soluble compound is not necessarily required to be easily soluble in the water. In this case, however, as described below, since the water-soluble compound is preferably homogeneously mixed with the photosensitive composition, the water-soluble compound should be satisfactorily miscible with the modified polysilsesquiazane and the solvents.

Specific examples of such compounds include 2-nitroaniline, 3-nitroaniline, 4-nitroaniline, 2-nitro-4-aminotoluene, 3-nitro-2-aminotoluene, 3-nitro-4-aminotoluene, 4-nitro-2-aminotoluene, 5-nitro-2-aminotoluene, 6-nitro-2-aminotoluene, 4-nitrobenzene-azo-orcinol, 1-(4-nitrobenzensulfonyl)-1 H-1,2,4-triazole, 5-nitrobenzimidazole, 4-nitrobenzylacetate, 2-nitrobenzylalcohol, 3-nitrobenzylalcohol, 4-nitrobenzylalcohol, nitrocyclohexane, 1-nitropropane, 2-nitropropane, nifedipine, 2,7-dinitrofluorene, 2,7-dinitro-9-fluorenone, 3,3'-dinitrobenzophenone, 3,4'- dinitrobenzophenone, propylene carbonate, ethylene carbonate, amide compounds such as trifluoroacetamide, ammonium trifluoroacetate, water-soluble acrylic polymers, water-soluble epoxy polymers, and water-soluble melamine polymers. Particularly suitable water-soluble compounds include 2-nitroaniline, 3-nitroaniline, 4-nitroaniline, 2-nitro-4-aminotoluene, propylene carbonate, ethylene carbonate, and water-soluble acrylic polymers.

The photosensitive composition according to the present invention may contain, as a shape stabilizer, the water-soluble compound in an amount of 0.01 to 50% by mass based on the mass of the modified polysilsesquiazane. The optimal mixing ratio varies depending upon the properties of individual water-soluble compounds. However, when the content of the water-soluble compound is smaller than 0.01% by mass, the effect of improving the slope of the side wall of the pattern is small. On the other hand, when the content of the water-soluble compound is larger than 50% by mass, problems associated with film properties after the development, such as defects and unsatisfactory strength occur. The content of the water-soluble compound in the mass of the modified polysilsesquiazane is preferably 0.05 to 40% by mass, more preferably 0.1 to 30% by mass.

The photosensitive composition of the present invention may be prepared by adding the above photoacid generating agent, optionally together with the water-soluble compound as the shape stabilizer, to the modified polysilsesquiazane. The photoacid generating agent and the water-soluble compound are preferably homogeneously mixed with the modified polysilsesquiazane. Methods desirably usable for achieving the homogeneous mixing include one wherein the modified polysilsesquiazane is mixed with the photoacid generating agent and the water-soluble compound while thorough stirring and one wherein each of them is diluted with a solvent which will be described later followed by mixing. In particular, in the mixing, when the photoacid generating agent and the water-soluble compound are solid, preferably, they are dissolved in a solvent before mixing. At the time of the addition of the photoacid generating agent and the water-soluble compound, the temperature and the pressure are not particularly limited, and the addition may be carried out at room temperature under atmospheric pressure. In order to avoid the excitation of the photoacid generating agent, the procedure from the addition of the photoacid generating agent to the step of development which will be described later is preferably carried out in an environment free from wavelengths photosensitive to the photoacid generating agent used, preferably in a dark place.

In some cases, mixing a sensitizing dye into the photosensitive composition according to the present invention is advantageous. For some photoacid generating agents, for example, 3,3',4,4'-tetra(t-butylperoxycarbonyl)benzophenone, the excitation wavelength region of the photoacid generating agent per se is shorter than about 330 nm. When light irradiation is carried out using an excimer laser, such as a KrF (248 nm) or ArF (193 nm) excimer laser, the photoacid generating agent is directly excited. Therefore, in this case, the use of the sensitizing dye is not necessary. When an inexpensive light source such as a high pressure mercury lamp (360 to 430 nm) is used, however, the combined use of the photosensitive composition and a sensitizing dye excited by this wavelength region can realize indirect excitation of the photoacid generating agent. Thus, the combined use of the photosensitive composition and the sensitizing dye can realize patterning of the photosensitive composition according to the present invention with a conventional inexpensive light source.

Sensitizing dyes usable in the photosensitive composition according to the present invention include coumarin, ketocoumarin, their derivatives, thiopyrilium salts and the like, specifically p-bis(o-methylstyryl)benzene, 7-dimethylamino-4-methylquinolone-2,7-amino-4-methylcoumarin, 4,6-dimethyl-7-ethylaminocoumarin, 2-(p-dimethylaminostyryl)-pyridyl-methyliodide, 7-diethylaminocoumarin, 7-diethylamino-4-methylcoumarin, 2,3,5,6-1 H,4H-tetrahydro-8-methylquinolizino-<9,9a, 1-gh>coumarin, 7-diethylamino-4-trifluoromethylcoumarin, 7-dimethylamino-4-trifluoromethylcoumarin, 7-amino-4-trifluoromethylcoumarin, 2,3,5,6-1H,4H-tetrahydroquinolizino-<9,9a,1-gh>coumarin, 7-ethylamino-6-methyl-4-trifluoromethylcoumarin, 7-ethylamino-4-trifluoromethylcoumarin, 2,3,5,6-1 H,4H-tetrahydro-9-carboethoxyquinolizino-<9,9a,1-gh>coumarin, 3-(2'-N-methylbenzimidazolyl)-7-N,N-diethylaminocoumarin, N-methyl-4-trifluoromethylpiperidino-<3,2-g>coumarin, 2-(p-dimethylaminostyryl)-benzothiazolylethyliodide, 3-(2'-benzimidazolyl)-7-N,N-diethylaminocoumarin, 3-(2'-benzothiazolyl)-7-N,N-diethylaminocoumarin, and pyrilium salts and thiopyrilium salts represented by the following formula.

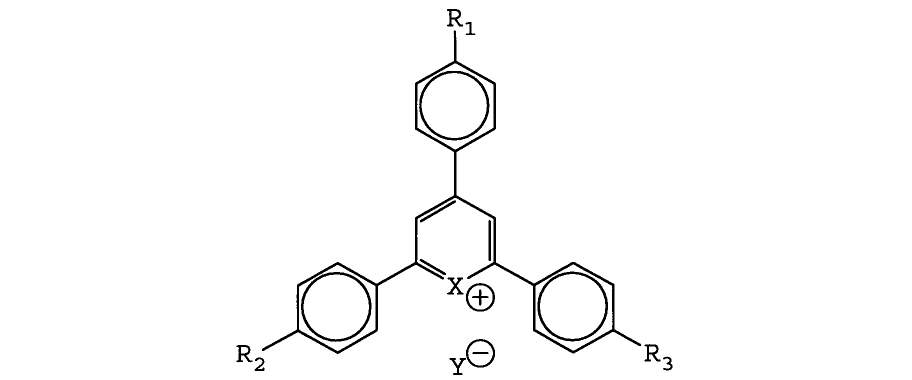

| X | R₁ | R₂ | R₃ | Y |
|---|---|---|---|---|
| | | | | |
| S | OC₄H₉ | H | H | BF₄ |
| S | OC₄H₉ | H | H | BF₄ |
| S | OC₄H₉ | OCH₃ | OCH₃ | BF₄ |
| S | H | OCH₃ | OCH₃ | BF₄ |
| S | N(CH₃)₂ | H | H | ClO₂ |
| O | OC₄H₉ | H | H | SbF₆ |

Specific examples of other sensitizing dyes include the following compounds.

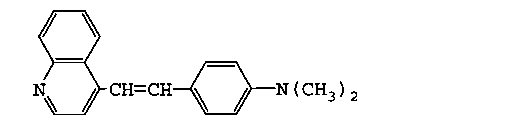

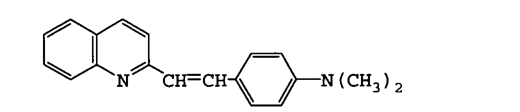

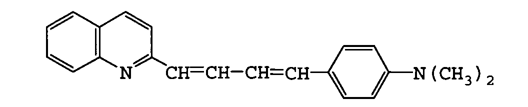

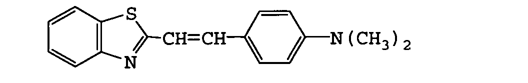

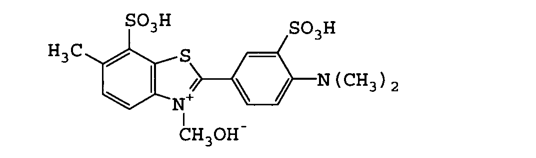

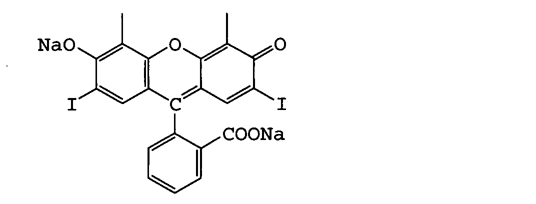

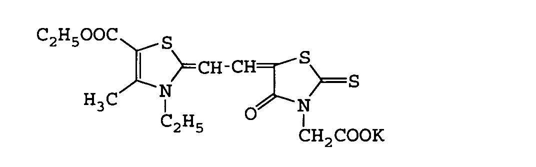

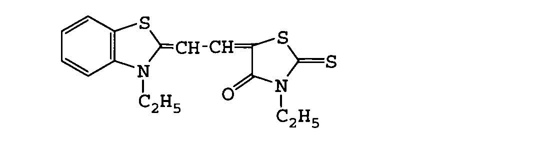

Particularly suitable sensitizing dyes include 7-diethylamino-4-methylcoumarin and 7-diethylamino-4-trifluoromethylcoumarin.

When the sensitizing dye is additionally used, the content of the sensitizing dye in the photosensitive composition according to the present invention may be generally 0.05 to 50% by weight, preferably 1 to 20% by weight, based on the weight of the modified polysilsesquiazane.

When the sensitizing dye is mixed into the photosensitive composition according to the present invention, the resultant film is sometimes colored. When the photosensitive composition of the present invention is used to form a patterned interlayer insulation film which is then applied to display devices or the like, however, in some cases, the interlayer insulation film after baking should be transparent to visible light. Even in this case, the photoacid generating agent contained in the photosensitive composition according to the present invention can decompose the sensitizing dye during baking of the film to render the interlayer insulation film after baking transparent to light.

Further, an interlayer insulation film having a higher level of transparency can be formed by separately adding an oxidation catalyst, which is not directly involved in the photoreaction but can decompose the sensitizing dye during baking of the film, to the photosensitive composition of the present invention. Examples of such oxidation catalysts include organic compounds and fine particles of metals such as palladium propionate, palladium acetate, platinum acetylacetonate, platinum ethylacetonate, fine particles of palladium, and fine particles of platinum. When the oxidation catalyst is added, the content of the oxidation catalyst in the photosensitive composition according to the present invention may be generally 0.05 to 10% by weight, preferably 0.1 to 5% by weight, based on the weight of the modified polysilsesquiazane. Further, the addition of the oxidation catalyst can realize decomposition of the unnecessary dye for decoloration, as well as the acceleration of the conversion of the modified polysilsesquiazane to a ceramic.

When a solvent is used, preferred are: aromatic compounds such as benzene, toluene, xylene, ethylbenzene, diethylbenzene, trimethylbenzene, and triethylbenzene; cyclohexane; cyclohexene; decahydronaphthalene; dipentene; saturated hydrocarbon compounds such as n-pentane, i-pentane, n-hexane, i-hexane, n-heptane, i- heptane, n-octane, i-octane, n-nonane, i-nonane, n-decane, and i-decane; ethylcyclohexane; methylcyclohexane; p-menthane; ethers such as dipropylether and dibutylether; ketones such as methyl isobutyl ketone (MIBK); and esters such as butyl acetate, cyclohexyl acetate, and butyl stearate. When these solvents are used, two or more of them may be used as a mixture from the viewpoint of regulating the solubility of the modified polysilsesquiazane and the evaporation rate of the solvent.

The amount (content) of the solvent is selected to provide good workability depending upon a coating method adopted. Further, since the amount (content) of the solvent varies depending upon the average molecular weight, the molecular weight distribution, and the structure of the modified polysilsesquiazane used, the solvent may be properly mixed. When the stability of the modified polysilsesquiazane and the productivity are taken into consideration, however, the concentration of the modified polysilsesquiazane is preferably 0.1 to 50% by weight, more preferably 0.1 to 40% by weight.

Further, the photosensitive composition according to the present invention may optionally contain a suitable filler and/or an extender. Examples of fillers include fine powder of inorganic oxides including silica, alumina, zirconia, and mica and inorganic nonoxides such as silicon carbide and silicon nitride. The addition of powder of a metal such as aluminum, zinc, or copper is also possible for some application. These fillers may be in various forms such as acicular (including whisker), particulate, and flaky forms which may be used either solely or as a mixture of two or more. The size of particles of these fillers is preferably smaller than the thickness of a film formed by single application. The amount of the filler added is in the range of 0.05 to 10 parts by weight, particularly preferably in the range of 0.2 to 3 parts by weight, based on one part by weight of the modified polysilsesquiazane.

The photosensitive composition according to the present invention may optionally contain various pigments, leveling agents, antifoaming agents, antistatic agents, ultraviolet absorbers, pH adjustors, dispersants, surface modifiers, plasticizers, drying accelerators, and flow preventives.

The present invention also provides a method for forming a patterned interlayer insulation film using the above photosensitive composition. Specifically, the method according to the present invention comprises the steps of: forming a coating of the above photosensitive composition for an interlayer insulation film; applying light pattern-wise to the coating; and dissolving and removing the coating in its exposed area.

The coating of the photosensitive composition according to the present invention may be formed on a suitable substrate such as a silicon substrate or a glass substrate by a conventional coating method such as dipping, roll coating, bar coating, brush coating, spray coating, flow coating, or spin coating. When the substrate is a film, the coating may be formed by gravure coating. If desired, the step of drying the coating may be provided separately.

The photosensitive composition may be coated once or twice or more repeatedly according to need to give a desired coating thickness. According to the present invention, the selection of the linking group other than the silazane bond can improve the film thickness limit. Therefore, a crack-free interlayer insulation film having a thickness of not less than 5.0 µm, preferably not less than 10.0 µm, can be provided.

After the formation of the coating of the photosensitive composition according to the present invention, the coating is preferably prebaked (heat-treated) from the viewpoints of drying the coating and reducing the amount of degassing in a later step. The step of prebaking may be generally carried out at 40 to 200°C, preferably 60 to 120°C, for 10 to 180 sec, preferably 30 to 90 sec, in the case of prebaking using a hot plate and for 1 to 30 min, preferably 5 to 15 min, in the case of prebaking in a clean oven.

The formation of the coating of the photosensitive composition according to the present invention and optional prebaking are followed by the application of light to the coating in a pattern-wise manner. Light sources usable herein include high pressure mercury lamps, low pressure mercury lamps, metal halide lamps, and excimer lasers. Light with wavelengths of 360 to 430 nm (from a high pressure mercury lamp) is generally used as irradiation light except for ultrafine patterning in the case of semiconductors or the like. Among others, in the case of liquid crystal display devices, light with a wavelength of 430 nm is in many cases used. In this case, as described above, the combination of the photosensitive composition according to the present invention with the sensitizing dye is advantageous.

The energy of the irradiation light may vary depending upon the light source and the desired film thickness. In general, however, the energy is 5 to 4,000 mJ/cm², preferably 10 to 2,000 mJ/cm². When the energy is less than 5 mJ/cm², the modified polysilsesquiazane is not satisfactorily decomposed. On the other hand, when the energy is higher than 4,000 mJ/cm², the exposure is excessive, sometimes leading to halation.

A conventional photomask may be used for pattern-wise irradiation, and the photomask is well known to a person having ordinary skill in the art.

The irradiation may be generally carried out in an environment such as an ambient atmosphere (the air) or a nitrogen atmosphere. Alternatively, an atmosphere enriched with oxygen may be adopted from the viewpoint of accelerating the decomposition of the modified polysilsesquiazane.

Upon exposure of a coating of the photosensitive composition to light in a pattern-wise manner, Si-N bonds of the modified polysilsesquiazane in the exposure area of the coating are cleaved, and the cleaved parts are further reacted with moisture in an atmosphere to give silanol (Si-OH) bonds and, thus, to decompose the modified polysilsesquiazane. When the coating after the exposure is developed, the photosensitive composition in its exposed area is removed while the unexposed area stays on the substrate to form a pattern (a positive-working pattern). Since the residual modified polysilsesquiazane is not substantially swollen in a developer which will be described later, the pattern of the irradiated light is substantially completely consistent with the pattern of the decomposed and removed modified polysilsesquiazane. Therefore, good pattern accuracy (resolution) can be provided.

In the removal of the exposed area of the modified polysilsesquiazane composition, that is, in the development, an aqueous alkaline solution may be used as a developer. Aqueous alkaline solutions usable herein include aqueous solutions of tetramethyl ammonium hydroxide (TMAH), sodium silicate, sodium hydroxide, potassium hydroxide and the like. In the development according to the present invention, the use of an about 2% aqueous TMAH solution, which is a standard alkaline developer in the industry, is convenient.

The time necessary for the development is generally 0.1 to 5 min, preferably 0.5 to 3 min, although it varies depending upon the film thickness and the solvent used. The development treatment temperature is generally 20 to 50°C, preferably 20 to 30°C.

Compounds known as the so-called "dissolution preventive" in the art may be added to the photosensitive composition according to the present invention from the viewpoint of enhancing the development efficiency. A conventional dissolution preventive prevents the elution of the polymer in the unexposed area of the coating into an alkaline developer by taking advantage of the hydrophobicity. In the exposed area, however, upon exposure or upon the action of the photoacid generating agent, the dissolution preventive per se is decomposed to develop hydrophilicity, thereby accelerating the decomposition of the polymer. As described above, the modified polysilsesquiazane according to the present invention is not dissolved in the developer and thus does not substantially enjoy the merit of dissolution preventive function of the dissolution preventive in the unexposed area. However, it has been found that, in the exposed area, the dissolution acceleration function can be advantageously exhibited. Specifically, the addition of the so-called "dissolution preventive" to the photosensitive composition according to the present invention can improve the development efficiency by virtue of increased dissolution rate of the exposed area. Specific examples of dissolution preventives include t-butoxycarbonylated (hereinafter referred to as "t-BOC") catechol, t-butoxycarbonylated hydroquinone, di-t-butyl benzophenone-4,4'-dicarboxylate, and di-t-butyl 4,4'-oxydibenzolate. The amount of the dissolution preventive added may be in the range of 0.1 to 40% by weight, preferably in the range of 1 to 30% by weight, based on the photosensitive composition.

Upon the development, the photosensitive modified polysilsesquiazane composition in its exposed area is removed to complete patterning. In order to use the patterned modified polysilsesquiazane film as an interlayer insulation film, the patterned modified polysilsesquiazane film may be allowed to stand for a long period of time or may be baked to convert the patterned modified polysilsesquiazane film to an excellent silica-based ceramic film having high heat resistance, low permittivity, transparency and other properties. When the modified polysilsesquiazane film is allowed to stand after the development, standing generally in an ambient atmosphere (in the air at room temperature) for a long period of time, for example, for one day or longer suffices for contemplated results. On the other hand, when the modified polysilsesquiazane film is baked, the baking temperature is generally 50 to 1000°C, preferably 100 to 1000°C, more preferably 150 to 450°C, although it may vary depending upon the type of the modified polysilsesquiazane used and the heat resistance of substrates, electronic components and the like. The baking time may be generally not less than 5 min, preferably not less than 10 min. The baking may be generally carried out in an ambient atmosphere (in the air). An atmosphere having increased oxygen content and/or partial pressure of water vapor, however, may be adopted from the viewpoint of accelerating the oxidation of the modified polysilsesquiazane.

The interlayer insulation film provided by the present invention has a permittivity of not more than 5 and, in some cases, a permittivity of not more than 3.3, and a resistivity of not less than 10¹³ Ωcm.

The following examples further illustrate the present invention.

### Comparative Example 1

The inside of a four-necked flask equipped with a gas inlet tube, a mechanical stirrer, and a Dewar condenser was purged with dry nitrogen. Thereafter, a starting solution was prepared in the flask by diluting methyltrichlorosilane (CH₃SiCl₃) with pyridine to give a monomer concentration of 10% by weight and was cooled on ice. Ammonia (NH₃) was mixed little by little into the starting solution through the gas inlet tube to cause an ammonolysis reaction.

After the completion of the reaction, a polymer represented by - (SiCH₃(NH)_{1.5})ₙ- was obtained. This polymer had a weight average molecular weight (as determined using polystyrene as a standard) of 4729.

Next, the polymer was subjected to solvent displacement to give a propylene glycol monomethyl ether acetate (PGMEA) solution. To the solution was added 1% by weight, based on the mass of the polymer, of the following photoacid generating agent PAG-1. Thus, a photosensitive composition was prepared.
PAG-1:

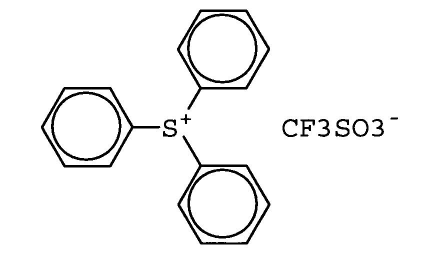

### Comparative Example 2

The inside of a four-necked flask equipped with a gas inlet tube, a mechanical stirrer, and a Dewar condenser was purged with dry nitrogen. Thereafter, a starting solution was prepared in the flask by diluting methyltrichlorosilane (CH₃SiCl₃) and 5% by mole, based on the amount of methyltrichlorosilane, of diphenylchlorosilane (Ph₂SiCl₂) with pyridine to give a total monomer concentration of 10% by weight and was cooled on ice. Ammonia (NH₃) was mixed little by little into the starting solution through the gas inlet tube to cause an ammonolysis reaction.

After the completion of the reaction, a copolymer represented by -(SiCH₃(NH)_{1.5})ₙ- and -(SiPh₂(NH))ₙ- was obtained. This polymer had a weight average molecular weight (as determined using polystyrene as a standard) of 4240.

Next, the copolymer was subjected to solvent displacement to give a xylene solution. To the solution was added 2% by weight, based on the mass of the polymer, of the following photoacid generating agent PAG-2. Thus, a photosensitive composition was prepared.
PAG-2:

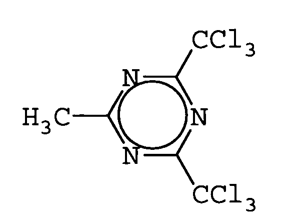

### Example 1

The inside of a four-necked flask equipped with a gas inlet tube, a mechanical stirrer, and a Dewar condenser was purged with dry nitrogen. Thereafter, a starting solution was prepared in the flask by diluting methyltrichlorosilane (CH₃SiCl₃) and 5% by mole, based on the amount of methyltrichlorosilane, of 1,4-bis(dimethylchlorosilyl)benzene (ClSi(CH₃)₂PhSi(CH₃)₂Cl) with pyridine to give a total monomer concentration of 10% by weight and was cooled on ice. Ammonia (NH₃) was mixed little by little into the starting solution through the gas inlet tube to cause an ammonolysis reaction.

After the completion of the reaction, a copolymer represented by -(SiCH₃(NH)_{1.5})ₙ- and -(SiMe₂PhSiMe₂(NH))ₙ- was obtained. This polymer had a weight average molecular weight (as determined using polystyrene as a standard) of 4866.

Next, the copolymer was subjected to solvent displacement to give a PGMEA solution. To the solution was added 2% by weight, based on the weight of the polymer, of the above photoacid generating agent PAG-2. Thus, a photosensitive composition was prepared.

### Example 2

The inside of a four-necked flask equipped with a gas inlet tube, a mechanical stirrer, and a Dewar condenser was purged with dry nitrogen. Thereafter, a starting solution was prepared in the flask by diluting methyltrichlorosilane (CH₃SiCl₃) and 5% by mole, based on the amount of methyltrichlorosilane, of 1,7-dichlorohexamethyltrisiloxane (ClSi(CH₃)₂OSi(CH₃)₂OSi-(CH₃)₂Cl) with pyridine to give a total monomer concentration of 10% by weight and was cooled on ice. Ammonia (NH₃) was mixed little by little into the starting solution through the gas inlet tube to cause an ammonolysis reaction.

After the completion of the reaction, a copolymer represented by -(SiCH₃(NH)_{1.5})ₙ- and -(SiMe₂OSiMe₂OSiMe₂(NH))ₙ- was obtained. This polymer had a weight average molecular weight (as determined using polystyrene as a standard) of 4438.

Next, the copolymer was subjected to solvent displacement to give a PGMEA solution. To the solution was added 2% by weight, based on the mass of the polymer, of the above photoacid generating agent PAG-2. Thus, a photosensitive composition was prepared.

### Example 3

The inside of a four-necked flask equipped with a gas inlet tube, a mechanical stirrer, and a Dewar condenser was purged with dry nitrogen. Thereafter, a starting solution was prepared in the flask by diluting methyltrichlorosilane (CH₃SiCl₃), 5% by mole, based on the amount of methyltrichlorosilane, of dimethyldichlorosilane ((CH₃)₂SiCl₂), and 10% by mole, based on the amount of methyltrichlorosilane, of 1,4-bis(dimethylchlorosilyl)benzene (ClSi(CH₃)₂PhSi(CH₃)₂Cl) with pyridine to give a total monomer concentration of 10% by weight and was cooled on ice. Ammonia (NH₃) was mixed little by little into the starting solution through the gas inlet tube to cause an ammonolysis reaction.

After the completion of the reaction, a copolymer represented by -(SiCH₃(NH)_{1.5})ₙ-, -(SiMe₂(NH))ₙ-, and -(SiMe₂PhSiMe₂(NH))ₙ- was obtained. This polymer had a weight average molecular weight (as determined using polystyrene as a standard) of 4388.

Next, the copolymer was subjected to solvent displacement to give a PGMEA solution. To the solution was added 2% by weight, based on the weight of the polymer, of the above photoacid generating agent PAG-2. Thus, a photosensitive composition was prepared.

Each of the photosensitive compositions were measured for storage stability, film thickness limit, film hardness, and photosensitivity as follows.

### · Storage stability

Each photosensitive composition was adjusted to a concentration of 40% by weight and was then placed and hermetically sealed in a 100-ml glass bottle. Each of the glass bottles was stored in a thermostatic oven kept at 50°C for 5 days. The weight average molecular weight of the polymer before the storage was compared with the weight average molecular weight after the storage to evaluate the stability of the photosensitive composition. The lower the percentage increase in the molecular weight of the polymer, the better the stability of the photosensitive composition.

### · Film thickness limit

Photosensitive compositions having concentrations suitable for the formation of films having desired thicknesses on a glass substrate by spin coating at 500 rpm were provided. Coatings were formed in thicknesses increased from 3 µm at increments of 0.5 µm and were prebaked at 90°C for one min. The whole surface of the prebaked coatings was then irradiated with light emitted from a low pressure mercury lamp at 100 mJ/cm². The exposed coatings were exposed to a humidified environment of 30°C and 80% RH for 5 min, were then post-baked at 200°C for 3 min, and were finally baked at 300°C for 30 min. The substrates were cooled to room temperature and were then examined for cracking under an optical microscope. Film thickness limit values in the following table are the maximum film thickness which does not cause cracking.

### · Film hardness

For each photosensitive composition, a 1 µm-thick film baked at 300°C was provided by the above method. The hardness of the films thus formed were measured by a pencil hardness measurement method specified in JIS (Japanese Industrial Standards) K 5400 8.4.

### · Photosensitivity (sensitivity)

A silicon substrate, on which a thin silicon nitride film as an antireflection film had been deposited, was provided. Each of the photosensitive compositions was coated onto the silicon substrate to a thickness of 0.8 µm. Each coating was prebaked at 100°C for 90 sec, was then loaded in a KrF exposure system, and was exposed through a photomask, which can provide line and space patterns of 0.25 µm, while varying the exposure. The coatings were then exposed to a humidified environment of 40°C and 80% RH for 3 min, were then brought into contact with an aqueous tetramethylammonium hydroxide (TMAH) solution, were finally washed with pure water.

An exposure necessary for providing a desired 0.25 µm pattern line width was determined under an electron microscope and was defined as sensitivity. When the exposure is unsatisfactory, the line width is broadened (that is, the space width is narrowed). On the other hand, when the exposure is excessively large, the line width is narrowed (that is, the space width is broadened). The lower the sensitivity value, the higher the photosensitivity.

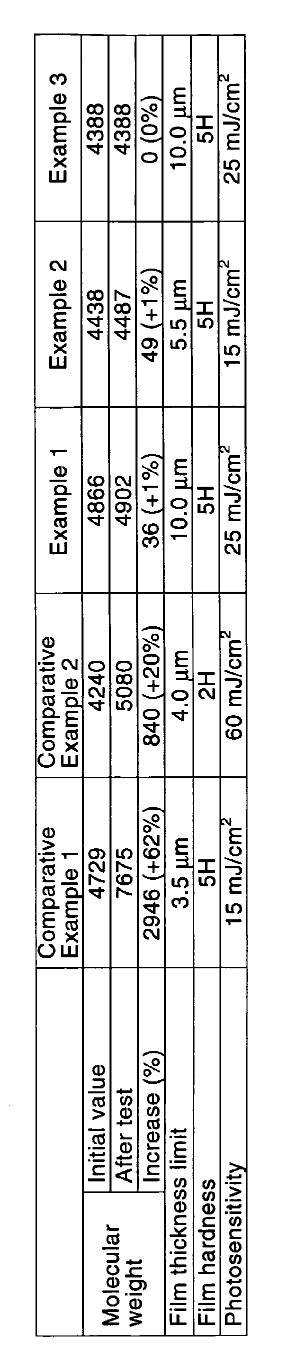

Table 1 shows that, for Examples 1 to 3 wherein a part of constitutional units of the polysilsesquiazane had been replaced by a linking group other than a silazane bond, the storage stability was significantly higher than that in the case of Comparative Examples 1 and 2 in which no such linking group had been provided in the constitutional units of the polysilsesquiazane. Likewise, for Examples 1 to 3, an improvement in the film thickness limit could be achieved over the film thickness limit in the case of Comparative Examples 1 and 2. In this connection, it should be particularly noted that, for Examples 1 and 3 wherein a benzene ring was contained in the principal chain of the polymer, the film thickness limit was 2.5 times larger than that in the case of Comparative Example 2 wherein a benzene ring was contained in the side chain. It is also apparent that an improvement in properties in Examples 1 to 3 could be achieved without sacrificing the film hardness. In this connection, it should be particularly noted that, for Examples 1 and 3 wherein a benzene ring was contained in the principal chain of the polymer, the film hardness was 2.5 times larger than that in the case of Comparative Example 2 wherein a benzene ring was contained in the side chain. It is also apparent that an improvement in properties in Examples 1 to 3 could be achieved without significantly sacrificing the photosensitivity. Rather, it should be noted that, for Examples 1 and 3 wherein a benzene ring was contained in the principal chain of the polymer, an improvement in photosensitivity could be achieved over the photosensitivity in the case of Comparative Example 2 wherein a benzene ring was contained in the side chain.

### Industrial Applicability

Thus, when a part of constitutional units of polysilsesquiazane is replaced by a linking group other than the silazane bond, the storage stability of a photosensitive composition can be enhanced without sacrificing the photosensitivity of the photosensitive composition and the hardness of an interlayer insulation film formed from the photosensitive composition. Further, the selection of the alternate linking group can enhance the film thickness limit of the interlayer insulation film formed from the photosensitive composition. Further, the insulation film formed from the photosensitive composition has low permittivity properties, is excellent in mechanical properties such as abrasion resistance, and can realize the formation of a fine pattern having excellent properties.

## Claims

1. A photosensitive composition for an interlayer insulation film, comprising a modified polysilsesquiazane having a weight average molecular weight of 500 to 200,000 comprising basic constitutional units represented by formula -[SiR¹(NR²)_{1.5}]- wherein R¹'s each independently represent an alkyl group having 1 to 3 carbon atoms or a substituted or unsubstituted phenyl group; R²'s each independently represent hydrogen, an alkyl group having 1 to 3 carbon atoms, or a substituted or unsubstituted phenyl group, up to 50% by mole of said basic constitutional units having been replaced by a linking group other than the silazane bond; and a photoacid generating agent.

2. The photosensitive composition for an interlayer insulation film according to claim 1, wherein said modified polysilsesquiazane further comprises 0.1 to 100% by mole, based on said basic constitutional units, of other constitutional units represented by formula -[SiR³₂NR²]- and/or [SiR³₃(NR²)_{0.5}]- wherein R³'s each independently represent hydrogen, an alkyl group having 1 to 3 carbon atoms, or a substituted or unsubstituted phenyl group; and R²'s each independently represent hydrogen, an alkyl group having 1 to 3 carbon atoms, or a substituted or unsubstituted phenyl group.

3. The photosensitive composition for an interlayer insulation film according to claim 1 or 2, wherein said linking group is represented by formula (I): 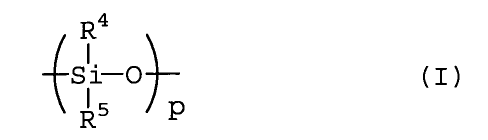 wherein R⁴ and R⁵ each independently represent hydrogen, or an alkyl, alkenyl, cycloalkyl, aryl, aralkyl, alkylamino, alkylsilyl, or alkoxy group; and p is an integer of 1 to 10.

4. The photosensitive composition for an interlayer insulation film according to claim 1 or 2, wherein said linking group is represented by formula (II): 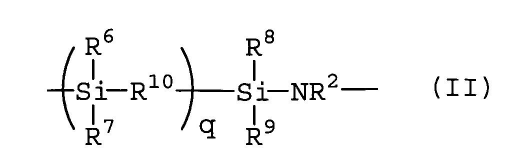 wherein R⁶, R⁷, R⁸, and R⁹ each independently represent an alkyl, alkenyl, cycloalkyl, aryl, aralkyl, alkylamino, alkylsilyl, or alkoxy group; R¹⁰ represents an oxygen atom or an alkylene, alkenylene, cycloalkylene, arylene, alkylimino, or alkylsilylene group; R²'s each independently represent hydrogen, an alkyl group having 1 to 3 carbon atoms, or a substituted or unsubstituted phenyl group; and q is an integer of 1 to 10.

5. The photosensitive composition for an interlayer insulation film according to claim 4, wherein R⁶, R⁷, R⁸, and R⁹ represent a methyl group, R¹⁰ represents a phenylene group, R² represents hydrogen, and q is 1.

6. The photosensitive composition for an interlayer insulation film according to any one of claims 1 to 5, wherein said photoacid generating agent is selected from the group consisting of sulfoxime compounds and triazine compounds.

7. The photosensitive composition for an interlayer insulation film according to any one of claims 1 to 6, which further comprises 0.1 to 40% by mass, based on the photosensitive composition, of a dissolution preventive selected from the group consisting of t-butoxycarbonylated catechol, t-butoxycarbonylated hydroquinone, di-t-butyl benzophenone-4,4'-dicarboxylate, and di-t-butyl 4,4'-oxydibenzolate.

8. The photosensitive composition for an interlayer insulation film according to any one of claims 1 to 7, which further comprises a nitro- or carbonic ester-containing water-soluble compound as a shape stabilizer.

9. The photosensitive composition for an interlayer insulation film according to any one of claims 1 to 8, which further comprises a sensitizing dye.

10. A method for forming a patterned interlayer insulation film, comprising forming a coating of a photosensitive composition for an interlayer insulation film as claimed in any one of claims 1 to 9, exposing said coating pattern-wise to light; dissolving and removing the coating in its exposed area; and subjecting the resultant patterned coating in an ambient atmosphere to standing or baking.
